(19) Europäisches Patentamt
European Patent Office
Office européen des brevets

(11) Veröffentlichungsnummer: **0 394 658 A1**

# (12) EUROPÄISCHE PATENTANMELDUNG

(21) Anmeldenummer: **90104846.2**

(51) Int. Cl.5: **C23C 14/06**

(22) Anmeldetag: **14.03.90**

(30) Priorität: **24.04.89 EP 89107394**

(43) Veröffentlichungstag der Anmeldung: **31.10.90 Patentblatt 90/44**

(84) Benannte Vertragsstaaten: **AT CH DE DK FR GB IT LI SE**

(71) Anmelder: **Siemens Aktiengesellschaft**
**Wittelsbacherplatz 2**
**D-8000 München 2(DE)**

(72) Erfinder: **Ebner, Heinz, Dipl.-Ing.**
**Karwendelstrasse 1**
**D-8027 Neuried(DE)**
Erfinder: **Stutz, Andreas, Dipl.-Phys.**
**Karl-Marx-Ring 92**
**D-8000 München 83(DE)**

## (54) Verfahren zum Herstellen von Dünnfilmwiderstandsschichten.

(57) In einer Stickstoff ($N_2$) als reaktives Gas enthaltenden Atmosphäre wird zur Bildung von stabilen und gleichmäßigen Dünnfilm-Widerstandsschichten Chromsilizid auf unbeheizte Substrate (S) aufgestäubt. Eine weitere Verbesserung der Widerstandsstabilität und des Temperaturkoeffizienten wird durch die Zugabe von Sauerstoff ($O_2$) als weiteres reaktives Gas erzielt. Vorzugsweise werden Chromsilizid-Schichten in einer Atmosphäre aufgestäubt, die aus einem Argon/Stickstoff- oder einem Argon/Stickstoff/Sauerstoff-Gemisch besteht. Erfindungsgemäß hergestellte Dünnfilm-Widerstandsschichten sind insbesondere für Widerstands-Netzwerte mit hohem Flächenwiderstand und für Heizelemente in Druckköpfen von Thermotransferdruckern und dergleichen geeignet.

FIG 1

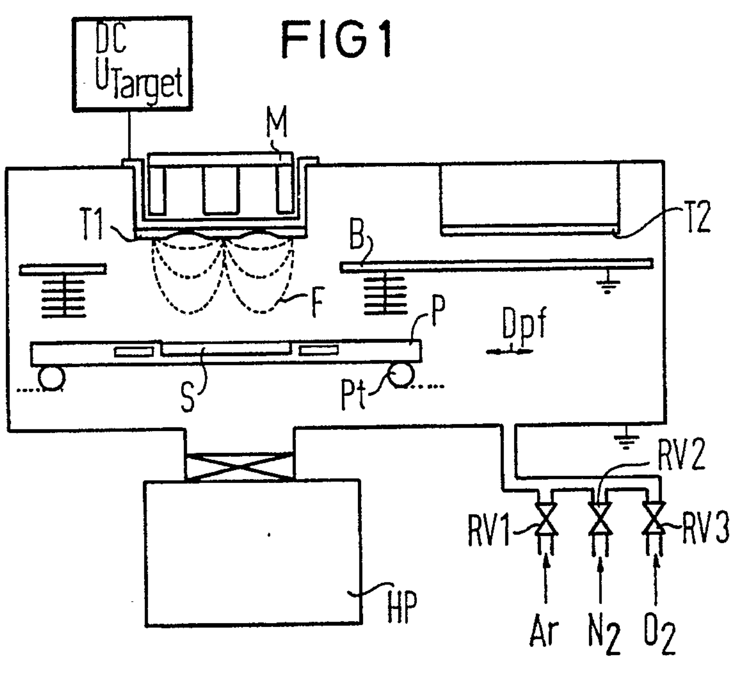


EP 0 394 658 A1

Die Erfindung betrifft ein Verfahren zum Herstellen von Dünnfilm-Widerstandsschichten, insbesondere für Widerstandsnetzwerke und für Heizelemente in Druckköpfen, durch reaktives Aufstäuben von Chromsilizid.

Für Widerstandsnetzwerke bzw. für Heizelemente in Druckköpfen werden stabile Dünnfilm-Widerstandsschichten mit spezifischen Widerständen >1000 $\mu\Omega$ cm und Temperaturkoeffizienten TKR< 200 x $10^{-6}$ benötigt. Bei Heizelementen wird zusätzlich noch eine Hochtemperaturbeständigkeit von mindestens 500° C gefordert.

Eine bekannte Möglichkeit zur Realisierung der vorstehend aufgeführten Anforderungen ist das reaktive Aufstäuben von Chromsilizid auf beheizte Substrate in einer Argon/Sauerstoff-Atmosphäre. Dieser Prozeß erfordert eine Aufstäubanlage, die die Beheizung der Substrate im Rezipienten auf eine Temperatur von ca. 400° C ermöglicht. Neben der gleichmäßigen Beheizung der Substrate ist auch der gleichmäßige Sauerstoffeinbau in die aufgestäubten Schichten schwierig zu bewerkstelligen, so daß die Herstellung einer einheitlichen Schicht insgesamt als problematisch anzusehen ist.

Der Erfindung liegt die Aufgabe zugrunde, ein Verfahren zum Herstellen von Dünnfilm-Widerstandsschichten zu schaffen, welches mit geringem Aufwand das reaktive Aufstäuben von gleichmäßigen Chromsilizid-Schichten ermöglicht.

Diese Aufgabe wird bei einem Verfahren der eingangs genannten Art dadurch gelöst, daß das Chromsilizid in einer Stickstoff als reaktives Gas enthaltenden Atmosphäre auf unbeheizte Substrate aufgestäubt wird.

Der Erfindung liegt die Erkenntnis zugrunde, daß bei der Verwendung von Stickstoff als reaktives Gas die reaktiven Prozesse beim Aufstäuben von Chromsilizid wesentlich unkritischer verlaufen als bei der Verwendung von Sauerstoff als reaktives Gas. Hierdurch können dann Chromsilizid-Schichten mit einer sehr hohen Schichtgleichmäßigkeit auf die Substrate aufgestäubt werden, was zu einer erheblichen Verbesserung der Ausbeute führt. Ein weiterer entscheidender Vorteil der Verwendung von Stickstoff als reaktives Gas ist, daß das Chromsilizid aus unbeheizte Substrate aufgestäubt werden kann. Durch den Wegfall der bislang erforderlichen Substratheizung kann dann der apparative Aufwand der eingesetzten Aufstäubanlage insgesamt erheblich reduziert werden.

Zur Erzielung möglichst hoher spezifischer elektrischer Widerstände der aufgestäubten Chromsilizid-Schichten hat es sich als besonders vorteilhaft erwiesen, wenn das Chromsilizid in einer mindestens 10 und höchstens 50 Vol. -% Stickstoff enthaltenden Atmosphäre aufgestäubt wird.

Eine weitere Steigerung der Widerstandsstabilität und des Temperaturkoeffizienten kann dadurch erreicht werden, daß das Chromsilizid in einer Stickstoff und Sauerstoff als reaktive Gase enthaltenden Atmosphäre aufgestäubt wird. Dabei ist es besonders günstig, wenn das Chromsilizid in einer Stickstoff und höchstens 20 Vol.-% Sauerstoff enthaltenden Atmosphäre aufgestäubt wird.

Gemäß einer bevorzugten Ausgestaltung des erfindungsgemäßen Verfahrens wird das Chromsilizid in einer Argon und Stickstoff enthaltenden Atmosphäre aufgestäubt. Das Argon hat hierbei die Aufgabe das aus Chromsilizid bestehende Target abzutragen. Im Hinblick auf die Widerstandsstabilität und den Temperaturkoeffizienten ist es dann auch besonders günstig, das Chromsilizid in einer Argon , Stickstoff und Sauerstoff enthaltenden Atmosphäre aufzustäuben.

Optimale Ergebnisse werden schließlich dann erzielt, wenn das Chromsilizid in einer Atmosphäre aufgestäubt wird, welche aus einem Argon/Stickstoff- oder einem Argon/Stickstoff/Sauerstoff-Gasgemisch besteht.

Im folgenden werden Ausführungsbeispiele der Erfindung anhand der Zeichnung näher erläutert.

Es zeigen

Fig. 1 eine Aufstäubanlage zum reaktiven Aufstäuben von Chromsilizid-Schichten in einer Argon/Stickstoff/Sauerstoff-Atmosphäre,

Fig. 2 den schematischen Aufbau eines elektrothermischen Wandlers für die Druckköpfe von Thermodruckern,

Fig. 3 eine Variante des in Fig. 2 dargestellten Schichtaufbaus und

Fig. 4 den spezifischen Widerstand von in einer Argon/Stickstoff/Sauerstoff-Atmosphäre aufgestäubten Chromsilizid-Schichten in Abhängigkeit vom Sauerstoff-Gehalt bei konstanten Stickstoff-Gehalten.

Fig. 1 zeigt in stark vereinfachter schematischer Darstellung eine Aufstäubanlage Typ MRC 943 der Materials Research Company, Orangeburg, New York 10962, USA. In dieser Aufstäubanlage, die eine Leistung von 500 Watt aufweist, befindet sich ein Chromsilizid-Target T1 an welches eine Spannung $U_{Target}$ von ca. 200 V angelegt ist. Zusätzlich ist ein Magnetron M vorgesehen, welches die gestrichelt eingezeichneten Feldlinien F erzeugt und mit Gleichstrom betrieben wird. Die Aufstäubanlage wird über ein Hochvakuum-Pumpsystem HP zunächst auf einen Druck von weniger als 5 x $10^{-7}$ Torr evakuiert, worauf sich nach dem Einleiten von Argon Ar, Stickstoff $N_2$ und Sauerstoff $O_2$ ein Arbeitsdruck von 5 x $10^{-3}$ Torr einstellt. Die Anteile des Argons Ar, des Stickstoffs $N_2$ und des Sauerstoffs $O_2$ in der Atmosphäre innerhalb der Aufstäubanlage werden dabei über entsprechende Regelventile RV1, RV2 und RV3 eingestellt. Der physikalische Abtrag des Chromsilizid-Targets T1 erfolgt durch Argon-Ionen, wobei das Chromsilizid mit Raten von 0,1 bis 1 µm pro Minute auf die mit S bezeichneten Substrate aufgestäubt wird. Der Stickstoff $N_2$ und der Sauerstoff $O_2$ dienen als reaktive Gase die beim reaktiven Aufstäubvorgang den Einbau von Stickstoff und Sauerstoff in die auf die Substrate S aufgestäubten Chromsilizid-Schichten bewirken.

Die Substrate S sind unterhalb des Chromsilizid-Targets T1 auf einer Palette angeordnet, die sich ihrerseits auf einem in Richtung des Doppelpfeiles Dpf verfahrbaren Palettenträger Pt befindet. Auf diese Weise können die Substrate S nach dem reaktiven Aufstäuben der Chromsilizid-Schichten zum Aufstäuben von Aluminium-Schichten unter ein Aluminium-Target T2 verfahren werden. Mit B sind Blenden bezeichnet, die als Abschirmungen beim Aufstäuben von Chromsilizid und Aluminium dienen.

Die in Fig. 1 dargestellte Aufstäubanlage ist äußerst einfach aufgebaut, da auf eine Beheizung der Substrate S verzichtet wird und die Substrattemperatur allein durch die Prozeßwärme beim reaktiven Aufstäuben bestimmt wird.

Nach dem Aufstäuben von Chromsilizid und Aluminium erfolgt eine Strukturierung der abgeschiedenen Schichten durch Fotoätztechniken, wobei als selektives Ätzmittel für die Leitschichten aus Aluminium ein Phosphorsäure/Salpetersäure-Gemisch und als selektives Ätzmittel für die Widerstandsschichten eine Mischung aus Ethylenglykol und Fluorid verwendet wird. An die Strukturierung der Schichten schließt sich dann eine Temperung bei einer Temperatur von ca. 500° C an.

Fig. 2 zeigt den Aufbau eines Thermowandlerelements im Querschnitt. Auf ein Substrat S1, welches beispielsweise aus $Al_2O_3$-Keramik besteht, ist als Thermo-Barriere TB1 eine 10 bis 50 µm starke Glasschicht aufgebracht. Mit DW1 ist eine 15 bis 40 nm starke Dünnfilm-Widerstandsschicht bezeichnet, die durch reaktives Aufstäuben von Chromsilizid in der in Fig. 1 dargestellten Aufstäubanlage erzeugt wurde. Darüber befindet sich eine Leitschicht L1 aus Aluminium, die in der gleichen Aufstäubanlage aufgebracht und anschließend strukturiert wurde. Die zwischen den strukturierten Leiterbahnen der Leitschicht L1 aus gesparte und mit Widerstandsmaterial unterlegte Fläche stellt die eigentliche Heizzone H1 des Thermowandlers dar. Bei bekannten Ausführungen ist die Dünnfilm-Widerstandsschicht DW1 im Bereich dieser Heizzone H1 mäanderförmig strukturiert, um einen geringeren Leiterbahnquerschnitt zu erzielen. Bei Verwendung höherohmiger Widerstandsmaterialien kann die Heizzone H1 auch ganzflächig von Widerstandsmaterial bedeckt sein. Ein höherer Leiterbahnquerschnitt wird dann von dem höheren Widerstandswert des Materials ausgeglichen. Zum Schutz der Dünnfilm-Widerstandsschicht DW1 und der Leitschicht L1 vor drohender Oxidation beim Betrieb des Thermowandlers, welcher zu einer enormen Temperaturerhöhung im Bereich der Heizzone H1 führt, ist eine Oxidationsschutzschicht O1 vorgesehen. Abschließend ist noch eine Abriebschutzschicht A1 aufgebracht, die in einigen Ausführungen mit der Oxidationsschutzschicht O1 zusammen eine Einheit bildet und z.B. aus gesputterten Siliziumdioxid bestehen kann.

Bei der in Fig. 3 dargestellten Variante des Schichtaufbaus eines Thermowandlers wurde auf ein mit S2 bezeichnetes Substrat im Bereich der späteren Heizzone H2 eine Thermo-Barriere TB2 aus Glas mit einem etwa halbkreisförmigen Querschnitt aufgebracht. Darüber befinden sich eine Diffusions-Barriere DB aus Siliziumdioxid und eine 15 bis 40 nm starke Dünnfilm-Widerstandsschicht DW2, die durch reaktives Aufstäuben von Chromsilizid in einer Argon/Stickstoff/Sauerstoff-Athmosphäre in einer Aufstäubanlage gemäß Fig. 1 aufgebracht wurde. Über der Dünnfilm-Widerstandsschicht DW2 befindt sich eine Leitschicht L2 aus Aluminium, die im Bereich der Heizzone H2 wieder entfernt worden ist. Den oberen Abschluß bildet eine kombinierte Schicht A2, die aus einer $SiO_2$-Schicht zur elektrischen Isolation und einer SiON-Schicht zum mechanischen Schutz zusammengesetzt ist.

Fig. 4 zeigt die Abhängigkeit des spezifischen Widerstands von in einer Argon/Stickstoff-Athmosphäre reaktiv aufgestäubten Chromsilizid-Schichten von dem Gehalt des zusätzlich als reaktives Gas verwendeten Sauerstoffs. Dabei ist über der Ordinate der spezifische Widerstand x $10^3$ in µΩ cm und über der Abszisse der Sauerstoff-Gehalt in Vol.-% aufgetragen. Die Kurven A, B und C geben einen jeweils konstanten Stickstoff-Gehalt von 28 bzw. 23 bzw. 17 Vol.-% an. Die Kurve D zeigt zu Vergleichszwecken die Abhängigkeit des spezifischen Widerstands vom Sauerstoff-Gehalt bei Chromsilizid-Schichten, die in einer reinen Argon-Sauerstoff-Athmophäre, d.h. ohne Anwesenheit von Stickstoff aufgestäubt wurden. Der Einfluß des Stickstoffgehalts auf die Höhe des spezifischen Widerstands ist ohne weiteres zu erkennen.

## Beispiel 1

In einer Athmosphäre mit 83 Vol.-% Argon und 17 Vol.-% Stickstoff wurde Chromsilizid auf ein unbeheiztes Substrat aufgestäubt. Die derart hergestellte Dünnfilm-Widerstandsschicht weißt einen spezifischen Widerstand von 900 µΩ cm auf.

## Beispiel 2

In einer Atmosphäre mit 64 Vol.-% Argon, 30 Vol.-% Stickstoff und 6 Vol.-% Sauerstoff wurde Chromsilizid auf ein unbeheiztes Substrat aufgestäubt. Die derart hergestellte Dünnfilm-Widerstandsschicht weist einen spezifischen Widerstand von 5000 $\mu\Omega$ cm auf.

Beispiel 3

In einer Atmosphäre mit 67 Vol.-% Argon, 23 Vol.-% Stickstoff und 10 Vol.-% Sauerstoff wurde Chromsilizid auf ein unbeheiztes Substrat aufgestäubt. Die derart hergestellte Dünnfilm-Widerstandsschicht wies einen spezifischen Widerstand von 250 $\mu\Omega$ cm auf.

**Ansprüche**

1. Verfahren zum Herstellen von Dünnfilm-Widerstandsschichten, insbesondere für Widerstandsnetzwerte und für Heizelemente in Druckköpfen, durch reaktives Aufstäuben von Chromsilizid,
**dadurch gekennzeichnet,**
daß das Chromsilizid in einer Stickstoff ($N_2$) als reaktives Gas enthaltenden Atmosphäre auf unbenützte Substrate (S;S1;S2) aufgestäubt wird.

2. Verfahren nach Anspruch 1,
**dadurch gekennzeichnet,**
daß das Chromsilizid in einer mindestens 10 und höchstens 50 Vol.-% Stickstoff ($N_2$) enthaltenden Atmosphäre aufgestäubt wird.

3. Verfahren nach Anspruch 1 oder 2,
**dadurch gekennzeichnet,**
daß das Chromsilizid in einer Stickstoff ($N_2$) und Sauerstoff ($O_2$) als reaktive Gase enthaltenden Atmosphäre aufgestäubt wird.

4. Verfahren nach Anspruch 3,
**dadurch gekennzeichnet,**
daß das Chromsilizid in einer Stickstoff ($N_2$) und höchstens 20 Vol.-% Sauerstoff ($O_2$) enthaltenden Atmosphäre aufgestäubt wird.

5. Verfahren nach einem der vorhergehenden Ansprüche,
**dadurch gekennzeichnet,**
daß das Chromsilizid in einer Argon (Ar) und Stickstoff ($N_2$) enthaltenden Atmosphäre aufgestäubt wird.

6. Verfahren nach einem der Ansprüche 1 bis 4,
**dadurch gekennzeichnet,**
daß das Chromsilizid in einer Argon (Ar), Stickstoff ($N_2$) und Sauerstoff (02) enthaltenden Atmosphäre aufgestäubt wird.

7. Verfahren nach einem der Ansprüche 1 bis 4,
**dadurch gekennzeichnet,**
daß das Chromsilizid in einer Atmosphäre aufgestäubt wird, welche aus einem Argon/Stickstoff- oder einem Argon/Stickstoffsauerstoff-Gasgemisch besteht.

FIG 1

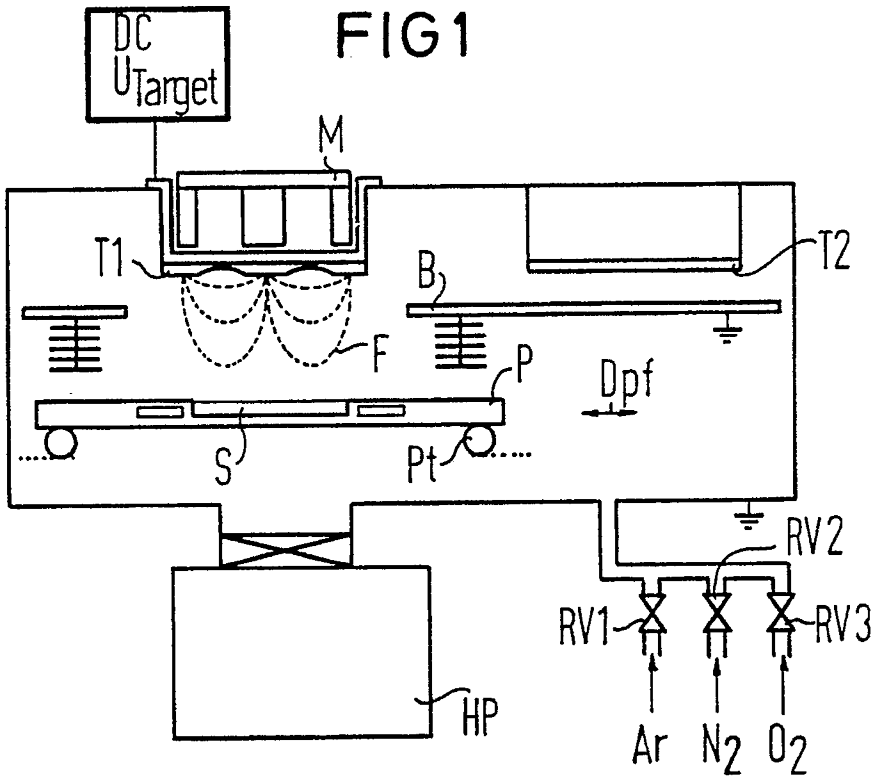


FIG 2

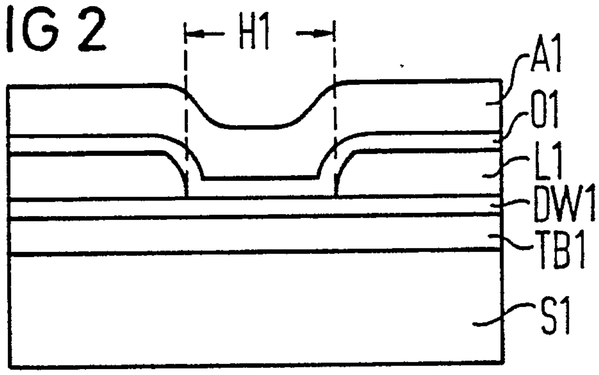


FIG 3

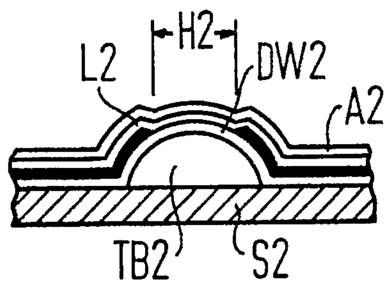

FIG 4

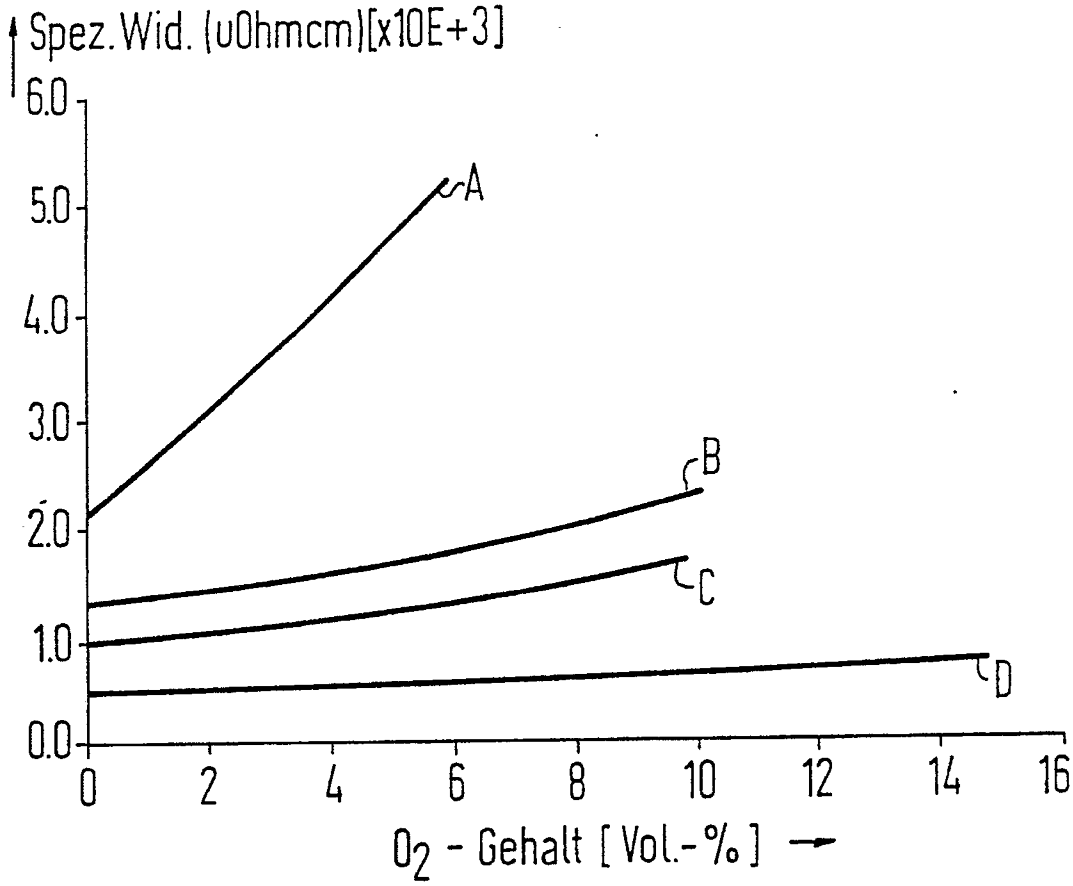
Spez. Wid. (uOhmcm)[x10E+3]
6.0
5.0
4.0
3.0
2.0
1.0
0.0
A
B
C
D
0
2
4
6
8
10
12
14
16
O2 - Gehalt [Vol.-%]

Europäisches Patentamt

# EUROPÄISCHER RECHERCHENBERICHT

Nummer der Anmeldung

EP 90 10 4846

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 569 742 (JAMES A. SCHUETZ)<br>* Zusammenfassung; Spalte 2, Zeilen 18-40; Spalte 4, Zeile 26 - Spalte 5, Zeile 45; Anspruch 1 * | 1,5,7 | C 23 C 14/06 |
| A | * Spalte 4, Zeile 26 - Spalte 5, Zeile 45 *<br>--- | 2 | |
| X | INSPEC, AN=89:3302321; A. HEINRICH et al.: "Electrical and structural properties of resistive thin films on the basis of CrSi(O,N)", & MATERIALS SCIENCE (1987), vol. 13, no. 3-4, p. 111-16<br>* Das ganze Dokument *<br>--- | 1,7 | |
| A | THIN SOLID FILMS, Band 128, Nr. 1/2, Juni 1985, Seiten 149-159, Elsevier Sequoia, Lausanne, CH; G. SOBE et al.: "Deposition of Cr-Si thin films by reactive plasmatron-magnetron sputtering"<br>* Seite 150, Absatz 2.1 *<br>--- | 3,4,6,7 | RECHERCHIERTE SACHGEBIETE (Int. Cl.5) |
| A | THIN SOLID FILMS, Band 96, Nr. 4, Oktober 1982, Seiten 279-284, Elsevier Sequoia, Lausanne, CH; S. SCHILLER et al.: "Cr-Si resistive films produced by magnetron-plasmatron sputtering"<br>* Seite 281, Absatz 3.2 *<br>--- | 3,4,6,7 | C 23 C |
| A | DE-A-2 909 804 (SIEMENS AG)<br>* Seite 6, Zeilen 3-12; Seite 6, Zeile 20 - Seite 7, Zeile 14 *<br>--- -/- | 3,4,6,7 | |

Der vorliegende Recherchenbericht wurde für alle Patentansprüche erstellt

| Recherchenort | Abschlußdatum der Recherche | Prüfer |
|---|---|---|
| DEN HAAG | 01-08-1990 | JOFFREAU P.O. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)

Europäisches Patentamt

# EUROPÄISCHER RECHERCHENBERICHT

Nummer der Anmeldung

EP 90 10 4846

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,P | US-A-4 846 949 (YUE-TUNG TU et al.)<br>* Zusammenfassung; Spalte 6, Zeile 61 - Spalte 7, Zeile 15; Spalten 7-8; Tafel 1; Anspruch 1 *<br>--- | 1,2,5,7 | |
| A,P | US-A-4 846 949<br>* Spalte 9, Zeilen 5-8 *<br>----- | 3,4,6 | |
| | | | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 01-08-1990 | JOFFREAU P.O. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)